# EUROPEAN PATENT APPLICATION

(11) **EP 4 832 670 A2**
(43) Date of publication of application: **28.10.2026**
(21) Application number: 26205288.9
(22) Date of filing: 16.09.2022
(51) Int. Cl.: H05K 1/02

(54) **HORN APERTURE FOR A SIMPLIFIED MMWAVE PHASED ARRAY ANTENNA**

(30) Priority: 22.09.2021 US 202163261487 P
(62) Document number(s) of the earlier application(s) in accordance with Art. 76 EPC: 22873789.6 / 4 402 756
(71) Applicant: Jabil Inc., St. Petersburg, FL 33716 (US)
(72) Inventor: TIMMINS, Ian, Jeffery, St. Petersburg, FL, 33716 (US); RAFIE, Babak, Zarrin, St. Petersburg, FL, 33716 (US); FALTONE, Youssef, St. Petersburg, FL, 33716 (US); FINNELL, John, St. Petersburg, FL, 33716 (US)
(74) Representative: Gulde & Partner

(57) **Abstract**

An antenna (10, 70) comprising a printed circuit board, PCB, structure (12, 72) including a stack of layers (74) and a via (82) extending through the stack of layers (74). A plurality of prepreg buildup layers (86) are formed on one side of the PCB structure (12, 72) and a plurality of prepreg buildup layers (96) are formed on an opposite side of the PCB structure (12, 72). A plurality of microvias (88) are formed through the prepreg buildup layers (86) on the one side and a plurality of microvias (98) are formed through the prepreg buildup layers (96) on the opposite side, both in electrical contact with the via (82) extending through the stack of layers (74). At least one beamforming integrated circuit, IC (18, 92) is formed on the plurality of prepreg buildup layers (86) on the one side of the PCB structure (12, 72). A metal layer (22, 102) is formed on an outermost one of the plurality of prepreg buildup layers (96) on the opposite side of the PCB structure (12, 72). The antenna (10, 70) further comprises at least one horn antenna radiating element (26, 40, 100) including a feed structure (30, 58) formed in the outermost one of the plurality of prepreg buildup layers (96) and a horn aperture (28, 42, 104) extending from the feed structure (30, 58) into the metal layer (22, 102).

## Description

### BACKGROUND

### Field

This disclosure relates generally to a millimeter wave (mmWave) antenna and, more particularly, to a mmWave phased array antenna including an array of horn antenna radiating elements.

### Discussion of the Related Art

Cellular telecommunications companies began deploying fifth generation (5G) radio technology standard for cellular networks in 2019. The 5G radio standard utilizes a higher frequency spectrum than previous generations of commercial communications technologies. MmW phased array antennas are being designed and developed for the 5G protocol that provides increased performance over 4G systems while also reducing costs. 5G mmWave antennas typically require precise manufacturing of printed circuit boards (PCBs) because antenna features on the order of a wavelength are at the limits of manufacturing tolerance of the PCB fabrication process. 5G mmWave phased array antennas utilize specialized low loss materials, and depending on the design approach, can produce complex and costly PCB designs that are difficult to manufacture, and thus are not well suited for high volume low cost manufacturing. Much of the layer count in the PCB is due to the height required for adequate bandwidth to be achieved with the antenna radiating elements.

US 20150070231 A1 discloses a substrate embedded horn antenna including a dielectric, a plurality of metal patterns, a plurality of metal vias, a ground plate, and a TX-RX integrated-circuit chip, wherein the plurality of metal patterns is embedded by being stacked in the dielectric and is hollow rectangle type or hollow circle type, and the plurality of metal patterns may form a waveguide structure by being stacked in a radial shape, and the TX-RX integrated-circuit chip is placed in the upper side of the dielectric and horizontally separated from the ground plate.

Takuro Tajima, ET AL: "300-GHz LTCC Horn Antennas Based on Antenna-in-package Technology", discloses a horn antenna integrated on a LTCC standard package, wherein a vertical horn structure is formed in the multi-layer LTCC surrounded by metal layers and the via fence, a metal pattern is printed on the upper side of the LTCC sheet, a MMIC is mounted in the air cavity of the package, and an on-chip coupler transition directly to the waveguide is also a possible solution.

Amin Enayati, ET AL: "Millimeter-Wave Horn-Type Antenna-in-Package Solution Fabricated in a Teflon-Based Multilayer PCB Technology", discloses a millimetre-wave horn-type antenna-in-package, wherein two laminates are used in the layer build-up: CLTE-AT, which is a Teflon-base laminate, and a Ceramic-based laminate called Ro4350 LoPro, a flip-chip technique is used to mount the RF-front-end die on layer 1 and the microwave signal is fed to a microstrip line on layer 1 which is connected to a microstrip-to-microstrip transition, the radiating part of the antenna element is implemented in the build-up by using thru metalized vias and ring-like patterns on layers 4, 5, and 6, and a radiating patch located on Layer 3 which is located inside the Horn-like region.

### SUMMARY

The following discussion discloses and describes a mmWave phased array antenna that has particular application to be used in a 5G radio. The antenna includes a PCB structure having a plurality of prepreg buildup layers including microvias on one side and on an opposite side. A plurality of beamforming integrated circuits (ICs) are formed on the prepreg buildup layers on the one side of the PCB structure and a plurality of horn antenna radiating elements are formed on the prepreg buildup layers on the opposite side of the PCB structure, where each of the horn antenna radiating elements includes a feed structure formed in one of the prepreg buildup layers and a horn aperture extending from the feed structure and formed in a metal layer.

Additional features of the disclosure will become apparent from the following description and appended claims, taken in conjunction with the accompanying drawings.

The present invention is directed to subject matter as defined in the appended set of claims. The description that follows is subjected to this limitation. Any disclosure lying outside the scope of said claims is only intended for illustrative as well as comparative purposes.

### BRIEF DESCRIPTION OF THE DRAWINGS

Figure 1 is a profile view of a mmWave phased array antenna including an array of horn antenna radiating elements;
Figure 2 is an isometric view of one of the horn antenna radiating elements separated from the antenna; and
Figure 3 is a profile view of a mmWave phased array antenna including a PCB structure and a horn antenna radiating element.

### DETAILED DESCRIPTION

The following discussion of the embodiments of the disclosure directed to a mmWave phased array antenna including a horn antenna radiating element is merely exemplary in nature, and is in no way intended to limit the disclosure or its applications or uses. For example, the discussion herein refers to the antenna as being part of a phased array antenna for a 5G radio. However, as will be appreciated by those skilled in the art, the antenna will have other applications.

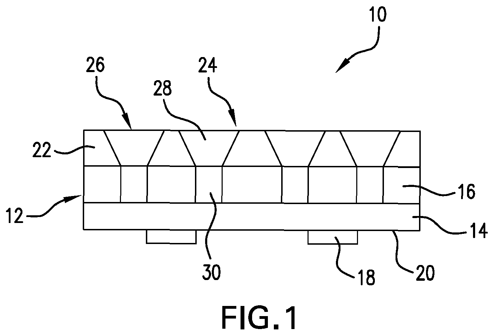

Figure 1 is a profile view of a mmWave phased array antenna 10, where the antenna 10 can be part of a 5G radio. The antenna 10 includes a PCB structure 12 having a bottom dielectric layer 14 and a top dielectric layer 16. A number of beamforming ICs 18 are formed on an outer surface 20 of the bottom layer 14 and include the circuitry necessary for beam phase combining and beam steering for multiple radiating elements in the phased array antenna 10 in a manner well understood by those skilled in the art. A metal plate 22 is formed on the top layer 16 and includes an array 24 of horn antenna radiating elements 26. The radiating elements 26 include a flared horn aperture 28 formed in the plate 22 and a feed structure 30 formed in the top layer 16 and feeding the aperture 28. The metal plate 22 can be bonded to the layer 16 using a conductive adhesive, or screwed to the bare copper such that electrical connectivity is maintained. A waveguide launch structure (not shown) is created in the top layer 16 using traces and vias.

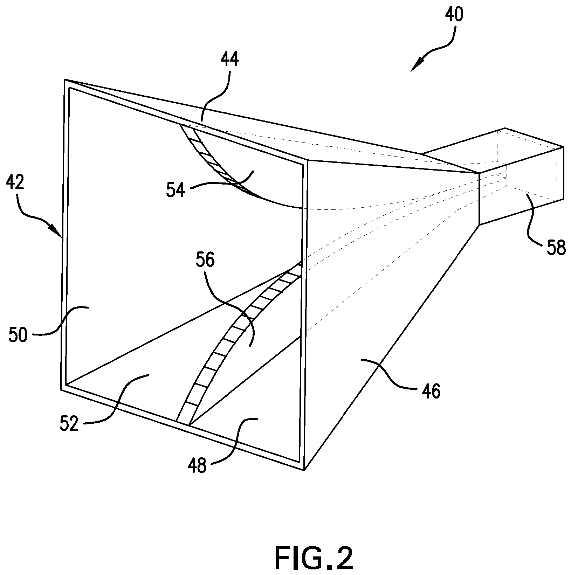

Figure 2 is an isometric view of a conductive horn antenna 40 that can be used as the horn antenna radiating elements 26. The antenna 40 includes a flared rectangular horn aperture 42 having flared sides 44, 46, 48 and 50 defining a waveguide 52. A tapered waveguide ridge 54 extends from the side 44 and into the waveguide 52 and a tapered waveguide ridge 56 extends from the side 48 and into the waveguide 52 so that the ridges 54 and 56 oppose each other. A feed structure 58 is coupled to the aperture 42 and includes the necessary signal generating circuitry (not shown) to feed the aperture 42 to propagate a signal at the desired polarity, such as vertically, horizontally or circularly polarized.

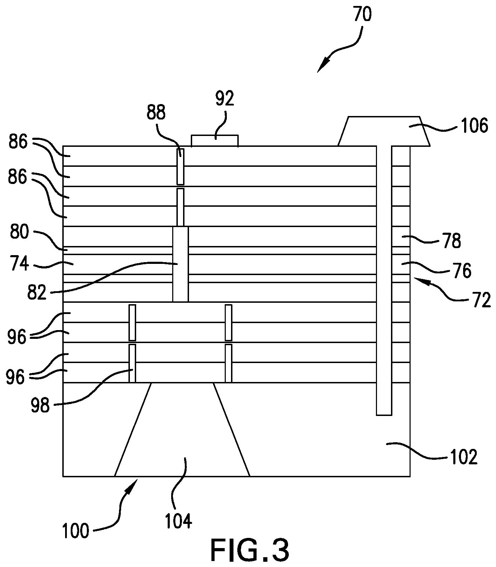

Figure 3 is a profile view of another mmWave phased array antenna 70, where the antenna 70 can be part of a 5G radio. The antenna 70 includes a PCB structure 72 having a stack of layers 74 including core dielectric layers 76, dielectric insulating prepreg layers 78 and a feed layer 80, where the number, thickness, configuration, material, etc. of the layers 74 would be designed for a particular antenna as would be well understood by those skilled in the art. A via 82 provides signal connection through the PCB structure 72. Prepreg buildup layers 86 are formed on a top of the PCB structure 72 and stacked microvias 88 are formed through the layers 86. A beamforming IC 92 is provided on top of the buildup layers 86 and includes the circuitry necessary for beam phase combining and beam steering for multiple radiating elements in the phased array antenna 70 in a manner well understood by those skilled in the art, where the vias 88 provide an electrical connection to the beamforming IC 92. Prepreg buildup layers 96 are formed on a bottom of the PCB structure 72 and stacked microvias 98 are formed through the layers 96. A horn antenna radiating element 100 is formed in a metal layer 102 on an outermost one of the layers 96 and would be one of many radiating elements formed on the PCB structure 72 to provide the phased array antenna 70. The radiating element 100 includes an aperture 104 formed in the layer 102 and a feed structure (not shown) formed in the outermost one of the layers 96. A screw 106 extends through the prepreg layers 86, the PCB structure 72 and the prepreg layers 96 to secure those layers to the metal layer 102.

In addition to the foregoing explanations, the following enumerated aspects 1 to 11 are also relevant for the present disclosure as part of the specification which must not be confused with the appended claims (that follow after the specification):
1. An antenna comprising: a printed circuit board (PCB) structure including a plurality of prepreg buildup layers on one side and on an opposite side; at least one beamforming integrated circuit (IC) formed on the prepreg buildup layers on the one side of the PCB structure; and at least one horn antenna radiating element formed on the prepreg buildup layers on the opposite side of the PCB structure, wherein the at least one horn antenna radiating element includes a feed structure formed in one of the prepreg buildup layers and a horn aperture extending from the feed structure outside of the prepreg layer.
2. The antenna according to aspect 1 wherein the horn aperture is formed in a metal layer.
3. The antenna according to aspect 1 wherein the horn aperture is tapered.
4. The antenna according to aspect 1 wherein the horn aperture includes opposing ridges extending into an aperture waveguide.
5. The antenna according to aspect 1 wherein the prepreg buildup layers include microvias.
6. The antenna according to aspect 1 wherein the antenna is a phased array antenna, the at least one beamforming IC is a plurality of beamforming ICs and the at least one horn radiating element is a plurality of horn radiating elements.
7. The antenna according to aspect 6 wherein the antenna is part of a 5G radio.
8. A phased array antenna comprising: a printed circuit board (PCB) structure including a plurality of prepreg buildup layers including microvias on one side and on an opposite side; a plurality of beamforming integrated circuits (ICs) formed on the prepreg buildup layers on the one side of the PCB structure; and a plurality of horn antenna radiating element formed on the prepreg buildup layers on the opposite side of the PCB structure, wherein each of the horn antenna radiating elements includes a feed structure formed in one of the prepreg buildup layers and a horn aperture extending from the feed structure formed in a metal layer.
9. The antenna according to aspect 8 wherein the horn apertures are tapered.
10. The antenna according to aspect 8 wherein the horn apertures include opposing ridges extending into an aperture waveguide.
11. The antenna according to aspect 6 wherein the antenna is part of a 5G radio.

The foregoing discussion discloses and describes merely exemplary embodiments of the present disclosure.

## Claims

1. An antenna (10, 70) comprising:
a printed circuit board, PCB, structure (12, 72) including a stack of layers (74) and a via (82) extending through the stack of layers (74);
a plurality of prepreg buildup layers (86) formed on one side of the PCB structure (12, 72);
a plurality of prepreg buildup layers (96) formed on an opposite side of the PCB structure (12, 72);
a plurality of microvias (88) formed through the plurality of prepreg buildup layers (86) on the one side of the PCB structure (12, 72) and in electrical contact with the via (82) extending through the stack of layers (74);
a plurality of microvias (98) formed through the plurality of prepreg buildup layers (96) on the opposite side of the PCB structure (12, 72) and in electrical contact with the via (82) extending through the stack of layers (74);
at least one beamforming integrated circuit, IC (18, 92), formed on the plurality of prepreg buildup layers (86) on the one side of the PCB structure (12, 72);
a metal layer (22, 102) formed on an outermost one of the plurality of prepreg buildup layers (96) on the opposite side of the PCB structure (12, 72); and
at least one horn antenna radiating element (26, 40, 100) including a feed structure (30, 58) formed in the outermost one of the plurality of prepreg buildup layers (96) on the opposite side of the PCB structure (12, 72) and a horn aperture (28, 42, 104) extending from the feed structure (30, 58) into the metal layer (22, 102).

2. The antenna (10, 70) according to claim 1, wherein the stack of layers (74) includes core dielectric layers (76), dielectric insulating prepreg layers (78) and a feed layer (80).

3. The antenna (10, 70) according to claim 1, wherein the horn aperture (28, 42, 104) is tapered.

4. The antenna (10, 70) according to claim 1, wherein the horn aperture (28, 42, 104) includes opposing ridges (54, 56) extending into an aperture waveguide (52).

5. The antenna (10, 70) according to claim 1, wherein the antenna (10, 70) is a phased array antenna, the at least one beamforming IC (18, 92) is a plurality of beamforming ICs and the at least one horn antenna radiating element (26, 40, 100) is a plurality of horn antenna radiating elements.

6. The antenna (10, 70) according to claim 1, wherein the antenna (10, 70) is part of a 5G radio.
